# EUROPÄISCHE PATENTANMELDUNG

(11) **EP 1 154 484 A2**
(43) Veröffentlichungstag der Anmeldung: **14.11.2001**
(21) Anmeldenummer: 01105068.9
(22) Anmeldetag: 02.03.2001
(51) Int. Cl.: H01L 27/02

(54) **ESD-Schutzstruktur und Verfahren zur Herstellung**

(30) Priorität: 08.05.2000 DE 10022367
(71) Anmelder: Micronas GmbH, 79108 Freiburg (DE)
(72) Erfinder: Czech, Martin, Dipl.-Ing., 79111 Freiburg (DE); Kessel, Jürgen, 79102 Freiburg (DE); Wagner, Eckart, Dipl.-Ing., 79279 Vörstetten (DE)
(74) Vertreter: Göhring, Robert, Dipl.-Ing.

(57) **Zusammenfassung**

Die Erfindung betrifft eine ESD-Schutzstruktur zum Schutz einer zwischen einer ersten Potentialschiene mit einem ersten Versorgungspotential und einer zweiten Potentialschiene mit einem zweiten Versorgungspotential geschalteten, integrierten Halbleiterschaltung vor elektrostatischer Entladung, mit einer lateral ausgebildeten ESD-Diode, die mindestens einen ersten Bereich des ersten Leitungstyps und mindestens einen vom ersten Bereich beabstandeten, zweiten Bereich des zweiten, entgegengesetzten Leistungstyps aufweist, die zwischen den Potentialschienen angeordnet ist und die einen Überspannungsimpuls auf eine Potentialschiene ableitet, mit einer Gateelektrode vorgesehen ist, wobei der erste Bereich und der zweite Bereich bezüglich der Gateelektrode justiert sind und der Abstand zwischen dem ersten Bereich und zweiten Bereich der Weite oder der Länge der Gateelektrode entspricht. Die Erfindung betrifft ferner ein Verfahren zur Herstellung einer solchen ESD-Schutzstruktur sowie ein Verfahren zur Herstellung einer Dotiermaske.

## Beschreibung

Die Erfindung betrifft eine ESD-Schutzstruktur der im Oberbegriff des Patentanspruchs 1 genannten Art sowie ein Verfahren zur Herstellung.

Im Betrieb einer integrierten Schaltung kommt es mitunter zu unerwünscht hohen Spannungsspitzen, die über die Versorgungsleitungen in die integrierte Schaltung eingekoppelt werden. Ohne geeignete Schutzmaßnahmen können bereits parasitäre Überspannungen von wenigen Volt und dadurch verursachte elektrostatische Entladungen (engl.: electrostatic discharge (ESD)) die integierte Schaltung irreversibel schädigen bzw. im Extremfall sogar zerstören, wodurch die Ausfallrate solcher integrierten Schaltungen unakzeptabel hoch wird. Das Problem der ESD-Verträglichkeit wird noch verschärft durch die Tatsache, dass mit zunehmender Chipintegration die Gateoxiddicken verringert werden und damit die Sensibilität der Gateoxide bei einem Überspannungsimpuls noch gesteigert wird.

Zur Verringerung der Ausfallrate enthalten in einem Chip integrierte Halbleiterschaltungen ESD-Schutzstrukturen zum Schutz gegen elektrostatische Überspannungen. Diese ESD-Schutzstrukturen sind auf der integrierten Schaltung mitintegriert. ESD-Schutzstrukturen können als Klemmschaltung zwischen den Versorgungsspannungsleitungen der integrierten Schaltung eingefugt werden und bei einer elektrostatischen Entladung die parasitäre Spannung auf eine Versorgungsleitung ableiten. Auf diese Weise kann die parasitäre Überspannung zwischen den Versorgungsspannungsleitungen auf verträgliche Werte reduziert werden.

Eine wesentliche Randbedingung bei der Herstellung von ESD-Schutzstrukturen ergibt sich aus der Forderung, dass diese unter Operationsbedingungen, wie sie zum Beispiel in der Produktspezifikation beschrieben sind, die Funktion der zu schützenden integrierten Halbleiterschaltung nicht oder nur unwesentlich beeinträchtigen dürfen. Das bedeutet, dass die Durchbruch- bzw. Durchschaltspannung des ESD-Schutzelements außerhalb des Signalspannungsbereichs der zu schützenden Schaltung liegen muss. Um eine gute Schutzwirkung entfalten zu können, sollte das ESD-Schutzelement also vor dem kritischen Schaltungspfad, jedoch noch außerhalb des Signalspannungsbereichs durchbrechen. Dies erfordert in der Regel eine exakte Einstellung der Durchbruch- bzw. Durchschaltspannung der jeweiligen ESD-Schutzelemente mit der wesentlichen Randbedingung, dass die Prozessführung, die hinsichtlich der Eigenschaften der Bauelemente der zu schützenden Schaltung optimiert wurde, durch das Einfügen der ESD-Schutzstruktur nicht oder nur unwesentlich verändert wird. Als ESD-Schutzelemente können daher zumindest teilweise sperrende Halbleiterbauelemente, wie beispielsweise Thyristoren, Bipolartransistoren, feldeffektgesteuerte Transistoren, oder Dioden verwendet werden.

Bei Verwendung eines Thyristors oder eines Transistors kann es im Betrieb bei sehr schnellen Störspannungsimpulsen zu einem unerwünschten Einschalten oder Zünden kommen, obwohl dessen durch Kennlinienmessung im Miederstrombereich bestimmte Einschalt- oder Zündspannung außerhalb des spezifizierten Signalspannungsbereichs liegt. Dieser sogenannte transiente Latch-up, der beliebig lange andauern kann, bewirkt einen Kurzschluss der Betriebsspannung und führt in der Regel zur Zerstörung des ESD-Schutzelementes, wodurch die Funktion der Halbleiterschaltung nicht mehr gewährleistet ist. Im Extremfall kann die Halbleiterschaltung und sogar deren Spannungsversorgung aufgrund einer starken Erwärmung (der integrierten Schaltung)irreversibel geschädigt werden. Auf Grund des transienten Latch-up's eignen sich ESD-Schutzelemente, die ein ausgeprägtes Snap-Back-Verhalten aufweisen, wie zum Beispiel Thyristoren oder Bipolartransistoren, trotz hoher ESD-Festigkeit und guter Schutzwirkung nur bedingt als ESD-Schutzelemente.

Die bisher bei integrierten Halbleiterschaltungen verwendeten ESD-Dioden haben die genannten Probleme nicht. In der DE 41 35 522 A1 ist eine solche gattungsgemäße ESD-Diode beschrieben.

Problematisch bei der Verwendung von pn-Dioden als ESD-Schutz ist jedoch die Tatsache dass sich pn-Dioden in normalen CMOS- oder MOS-Prozessen gar nicht oder nur mit erheblichem Aufwand integrieren lassen, da sie bei CMOS- oder MOS-Prozessen im Allgemeinen als parasitäre Stukturen vorhanden sind. Die Herstellung von solchen pn-Dioden als ESD-Schutz erfordert eine sehr aufwendige Kontrolle der Prozessparameter für die im CMOS-Prozess im Prinzip parasitaren pn-Strukturen. Bisherige pn-Dioden zeigen außerdem eine ungenügende Klemmwirkung, die nur durch Einführung von zusätzlichen Sonderprozessen, beispielsweise die Verwendung von Sondermasken, Verwendung von epitaktische Wafer, etc., zu beheben sind. Schließlich führen parasitäre Oberflächenladungen zu Leckströmen, die einen sogenannten "Wanderungseffekt" (engl.: walk out) der Diodenleckströme in der Diodenkennlinie insbesondere bei hohen Spannungen verursachen. Die Diode weist hier eine schlechte, dass heißt undefinierte Sperreigenschaft auf, wodurch ein erhebliches Zuverlässigkeitsproblem der pn-Diode als ESD-Schutz besteht.

Der vorliegenden Erfindung liegt daher die Aufgabe zugrunde, eine ESD-Schutzstruktur der eingangs genannten Art bereitzustellen, welche, auf sehr einfache Weise, möglichst ohne Veränderung der Prozesstechnologie, herstellbar ist. Ferner soll ein einfaches Verfahren zur Herstellung einer solchen ESD-Schutzstruktur angegeben werden.

Die anordnungsbezogene Aufgabe wird durch eine ESD-Schutzstruktur mit den Merkmalen des Patentanspruchs 1 gelost. Die verfahrensbezogene Aufgabe wird durch ein Verfahren mit den Merkmalen des Patentanspruchs 9 und durch ein Verfahren mit den Merkmalen des Patentanspruchs 13 gelost.
Vorteilhafte Ausgestaltungen und Weiterbildungen sind den Unteransprüchen, der Beschreibung und den Figuren der Zeichnung entnehmbar.

Die erfindungsgemäße ESD-Diode ist vorteilhafterweise sehr einfach im Aufbau und in der Herstellung, da hier lediglich das Layout eines bekannten MOS-Transistors herangezogen wird, bei dem am Sourcebereich oder am Drainbereich der Leitfähigkeitstyp ausgetauscht wird. Vorteilhafterweise sind hier keine zusätzlichen Prozessschritte, wie beispielsweise die Implantation zur Herstellung einer ESD-Zenerdiode oder die Herstellung einer vergrabenen Schicht oder einer Epitaxieschicht, notwendig, wodurch die erfindungsgemäße ESD-Diode sich sehr kostengünstig herstellen lässt.

Da die erfindungsgemäße ESD-Schutzstruktur als einfach pn-Diode ausgebildet ist, können keinerlei Probleme durch dauerhaften Kurzschluss, die beispielsweise die Spannungsversorgung oder die integrierte Schaltung schädigen können, auftreten. Die ESD-Diode kann vielmehr die Spannung hinreichend begrenzen, ohne dass die als Hochvoltschaltung ausgelegte integrierte Schaltung Schaden nehmen kann. Die erfindungsgemäße ESD-Diode eignet sich somit insbesondere für Hochspannungsanwendungen.

Die erfindungsgemäße ESD-Diode erfordert keinerlei besondere Prozessschritte oder zusätzliche Masken, die nicht ohnehin in dem MOS- oder CMOS-Prozess, der zur Herstellung der integrierten Schaltung erforderlich ist, vorhanden sind.

Da sich die erfindungsgemäße ESD-Diode aus einem gangigen MOS-Transistor, welcher ein Hauptelement eines MOS- bzw. CMOS-Prozesses darstellt, ableitet, "vererben" sich auch die Eigenschaften des prozesstechnisch sehr gut bekannten MOS-Transistors auf die Diode. Insbesondere kritische pn-Übergange zum Substrat und die oberflächennahen Bereiche des Gate-Oxides unterscheiden sich vorteilhafterweise nicht von den bekannten MOS-Transistoren.

Der besondere Vorteil bei der Herstellung besteht darin, dass die für die ESD-Diode erforderlichen Diffusions- oder Implantationsgebiete über die Gate-Elektrode selbstjustierend hergestellt werden können. Bei MOS- bzw. CMOS-Prozessen unterliegt die Herstellung des Gate-Oxides und der Gate-Elektrode einer sehr strengen Prozesskontrolle. Auf diese Weise lassen sich ESD-Dioden mit sehr exakt definierbaren lateralen Dimensionen herstellen, da Abweichungen in der Dimensionierung im Rahmen von ständig durchgeführten MOS-Parametermessungen ohnehin bemerkt werden würden. Auch andere potentielle Probleme der Diode, wie zum Beispiel Leckströme, Oberflächenladungen, Verunreinigungen, usw. würden die MOS-Transistoren der integrierten Schaltungen in demselben Maßstab betreffen und daher mit Standardkontrollen bemerkt werden. Fur die erfindungsgemäßen ESD-Dioden sind daher keine zusätzlichen Messungen auf dem Wafer erforderlich, was ein weiterer Wirtschaftlichkeitsvorteil ist.

Vorteilhafterweise ist die Gate-Elektrode mit derjenigen Elektrode kurzgeschlossen, die den absichtlich falsch dotierten Bereich kontaktiert. Auf diese Weise lässt sich sicherstellen, dass unerwünschte Oberflächeneffekte und dadurch verursachte Leckströme weitestgehend vermieden werden.

In einer Weiterbildung der Erfindung ist die ESD-Struktur in einer eigenen Wanne eingebettet und die entsprechenden Leitfahigkeitstypen daran angepasst. Die so in die Wanne eingebettete ESD-Struktur ist vom Substrat vorteilhafterweise isoliert.

In einer weiteren vorteilhaften Ausgestaltung ist jeweils ein Bereich der ESD-Diode, typischerweise der Anodenbereich, vollständig von dem die Kathode bildenden Bereich umschlossen, was insbesondere einen erhöhten Latch-up-Schutz bietet.
Vorteilhafterweise ist die integrierte Halbleiterschaltung und somit auch die ESD-Diode in MOS- oder CMOS-Prozesstechnologie hergestellt, das heißt, es ist ein Siliziumdioxid enthaltendes Gatedielektrikum vorgesehen, dass den Halbleiterkörper von der Gateelekektrode beabstandet. Die Gateelektrode ist dann typischerweise als Polysiliziumgate ausgebildet. Selbstverständlich ist die Erfindung auch für jede andere Prozesstechnologie vorteilhaft anwendbar, dass heißt die Gateelektrode und das Gateoxid könnten auch aus anderen Materialien bestehen. Denkbar wären auch ESD-Dioden ohne Gateoxid.

Die Erfindung wird nachfolgend anhand der in den Figuren der Zeichnung angegebenen Ausführungsbeispiele näher erläutert. Es zeigt dabei:
- Fig. 1: eine Schaltungsanordnung mit einer erfindungsgemäßen ESD-Diode;
- Fig. 2: in einem Teilschnitt ein erstes Ausführungsbeispiel einer erfindungsgemäßen integrierten ESD-Diode;
- Fig. 3: in einem Teilschnitt ein zweites Ausführungsbeispiel einer erfindungsgemäßen integrierten ESD-Diode;
- Fig. 4: in einem Teilschnitt ein drittes Ausführungsbeispiel einer erfindungsgemäßen integrierten ESD-Diode;

In allen Figuren der Zeichnung sind gleiche bzw. funktionsgleiche Elemente mit gleichen Bezugszeichen versehen.

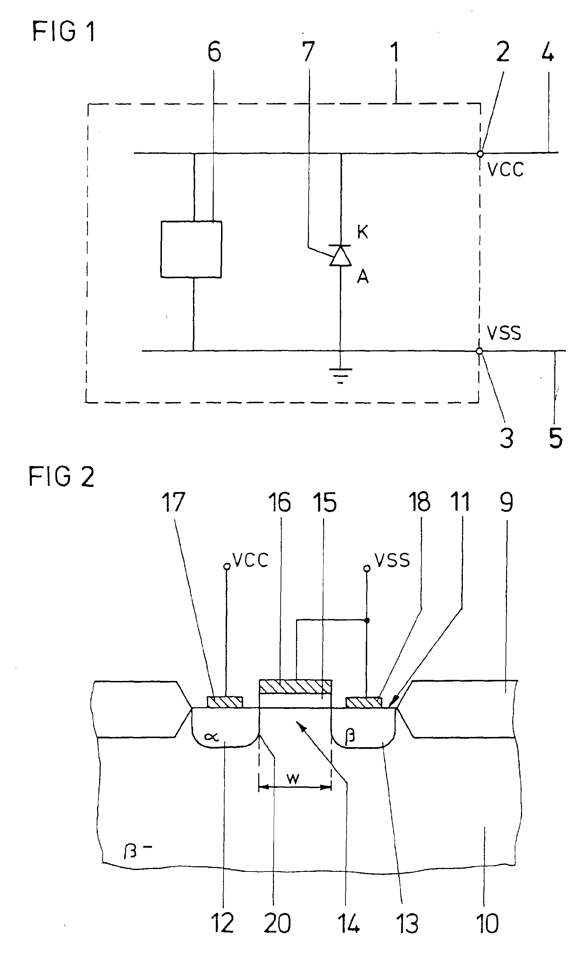

Figur 1 zeigt eine Schaltungsanordnung mit einer erfindungsgemäßen ESD-Diode. In Figur 1 ist mit 1 die integrierte Halbleiterschaltung bezeichnet. Die integrierte Halbleiterschaltung 1 ist über seine beiden Versorgungsspannungseingänge 2, 3 mit einer ersten Potentialschiene 4 mit einem ersten Versorgungspotential VCC sowie einer zweiten Potentialschiene 5 mit einem zweiten Versorgungspotential VSS, das im vorliegenden Beispiel die Bezugsmasse ist, verbunden.

Die integrierte Halbleiterschaltung 1 weist ferner eine zu schützende Schaltung 6, beispielsweise eine Logikschaltung, eine programmgesteuerte Einheit, ein Halbleiterspeicher, ein Leistungsschaltung, etc., auf. Ferner weist die integrierte Halbleiterschaltung 1 ein als Diode ausgebildetes ESD-Schutzelement 7 zum Schutz der zu schützenden Schaltung 6 auf. Die zu schützende Schaltung 6 sowie das ESD-Schutzelement 7 sind jeweils zwischen die erste und die zweite Potentialschiene 4, 5 geschaltet. Der erfindungsgemäße Aufbau einer solchen ESD-Diode 7 bzw. vorteilhafte Weiterbildungen werden nachfolgend anhand der Figuren 2 bis 4 ausführlich beschrieben.

Figur 2 zeigt in einem Teilschnitt ein erstes, verallgemeinertes Ausführungsbeispiel einer erfindungsgemäßen integrierten ESD-Diode entsprechend Figur 1.

In Figur 2 ist mit 10 ein Ausschnitt eines Halbleiterkörpers bezeichnet. Der Halbleiterkörper 10 besteht im vorliegenden Ausführungsbeispiel aus schwach β-dotiertem Siliziumsubstrat. Der Halbleiterkörper 10 weist eine Scheibenvorderseite 11 auf, in der ein erster, α-dotierter Bereich 12 sowie ein zweiter, β-dotierter Bereich 13 eingebettet sind. Die Bereiche 12, 13 sind voneinander beabstandet, wobei das Gebiet zwischen den Bereichen 12, 13 mit dem Abstand W ein Driftgebiet 14 definieren. Das Driftgebiet 14 weist die Hintergrunddotierung, das heißt die Dotierung des Halbleiterkörpers 10 auf. Im Ausführungsbeispiel gemäss Figur 2 bildet der erste Bereich 12 die Kathode und der zweite Bereich 13 und das Driftgebiet 14 die Anode der ESD-Diode. Wesentlich hierbei ist, dass der zweite Bereich 13 eine höhere Dotierungskonzentration als der Driftbereich 14 aufweist. Auf der Oberfläche 11 ist im Bereich des ersten Bereiches 12 und des zweiten Bereiches 13 jeweils eine Elektrode 17, 18 aufgebracht, die mit den jeweiligen Versorgungspotentialen VCC, VSS verbunden sind.

Erfindungsgemäß ist genau über dem Driftgebiet 14 ein Gate-Oxid 15 und auf dem Gate-Oxid 15 eine Gate-Elektrode 16 angeordnet. Das Gate-Oxid 15 besteht typischerweise aus Siliziumdioxid, die Gate-Elektrode 16 aus Polysilizium. Die Gate-Elektrode 16 ist elektrisch mit der Elektrode 18 des zweiten Bereiches 13 verbunden und ist damit an das zweite Versorgungspotential VSS angeschlossen.

Durch die entsprechend Figur 2 angeordneten und verschalteten Bereiche und Elemente 12 - 16 wird mithin auf sehr einfache, aber nichts desto trotz sehr effektive Weise die erfindungsgemäße ESD-Diode 7 bereitgestellt. Die an die Oberfläche 11 tretenden Bereiche außerhalb der ESD-Diode 7 sind typischerweise durch ein Feldoxid 19 bedeckt, welches in bekannter Art und Weise der lateralen Passivierung des Halbleiterkörpers 10 dient. Ferner kann die gesamte ESD-Diode 7 durch eine - in Figur 2 nicht dargestellte Passivierung - bedeckt sein.

Nachfolgend wird die Funktionsweise der erfindungsgemäßen lateralen ESD-Diode 7 entsprechend Figur 2 näher erläutert.

Wird über eine Potentialschiene 2, 3 ein parasitäres Störsignal, das beispielsweise beim Transport bzw. beim Handling durch elektrostatische Aufladung auf dem Halbleiterchip oder auch durch Schwankung in der Versorgungsspannung entstehen kann, in die integrierte Schaltung 1 eingekoppelt und überschreitet dieses Störsignal die Durchbruchspannung der ESD-Diode 7, dann bricht bei Überschreiten der Durchbruchspannung die Raumladungszone am pn-Übergang 20 zwischen erster Zone 12 und Driftzone 14 zusammen und die ESD-Diode 7 schaltet durch. Somit ergibt sich ein Strompfad von der ersten Potentialschiene 2 über die erste Zone 12, die Driftzone 14, die zweite Zone 13 zur zweiten Potentialschiene 3. Die erfindungsgemäße ESD-Diode 7 schützt somit die integrierte Halbleiterschaltung 1 vor einer parasitären Überspannung, indem diese an die Potentialschienen 5 abgeleitet wird und damit nicht oder nur stark abgeschwächt in die integrierte Halbleiterschaltung 1 gelangt.

Dadurch, dass die Gate-Elektrode 16 über der Driftzone 14 angeordnet ist und mit dem zweiten Versorgungspotential VSS verbunden ist, im vorliegenden Fall ist das das Potential der Bezugsmasse, werden unerwünschte Oberflächeneffekte, wie zum Beispiel parasitäre Oberflächenladungen und dadurch resultierende Oberflächenleckströme, eliminiert. Die Verlasslichkeit der ESD-Diode wird dadurch in erheblichem Maße gesteigert.

Unter Operationsbedingungen dürfen die ESD-Schutzelemente die Funktion der integrierten Halbleiterschaltung 1 nicht beeinträchtigen. Die Durchbruchspannung der ESD-Diode 7 muss daher in einem Spannungsbereich liegen, dessen untere Grenze die maximal in die integrierte Halbleiterschaltung 1 eingekoppelte Signalspannung ist und dessen obere Grenze durch die minimale Durchbruchspannung der integrierten Halbleiterschaltung 1 gekennzeichnet ist. Wesentlich hierbei ist, dass die Durchbruchspannung der ESD-Diode 7 moglichst exakt einstellbar ist, um so trotz Prozessschwankungen bei der Herstellung der integrierten Halbleiterschaltung 1 und der ESD-Diode 7 noch funktionsfähig zu sein.

Die exakte Einstellung der Durchbruchspannung der ESD-Diode 7 kann durch die Dotierungskonzentrationen in den Zonen 12, 13 und 14 eingestellt werden. Jedoch besteht - wie bereits eingangs erwähnt - eine wesentliche Randbedingung bei der Herstellung von ESD-Schutzstrukturen darin, dass die Prozessführung durch das Einfügen der ESD-Schutzstrukturen möglichst nicht verändert wird, so dass die Dotierungskonzentrationen und/oder die Dicke des Gateoxids 15 möglichst nicht verändert werden sollen.

Als ESD-Elemente werden hier die Layouts von gängigen lateralen MOSFETs, die auch für die entsprechende MOS- oder CMOS-Schaltung zum Einsatz kommen, verwendet. Im Layout dieser MOSFETs wird jedoch der Leitfähigkeitstyp von Sourcebereich oder von Drainbereich vertauscht. Damit wird mit verhältnismäßig einfachen Mitteln eine pn-Diode 7 als ESD-Schutz bereitgestellt, die vorteilhafterweise in MOS- oder CMOS-Technologie hergestellt wird. Unter Verwendung der MOS- oder CMOS-Technologie der zu schützenden Schaltung 2 wird gewährleistet, dass die Prozessparameter der ESD-Diode 7 ebenfalls optimal kontrollierbar und somit definiert einstellbar sind.

Als Dotierungsmaske kann ein gängiges Feldoxid, das beispielsweise in LOCOS-Technologie hergestellt ist, oder auch jede andere Maskierung, beispielsweise ein Photolack dienen. Besonders vorteilhaft ist es, wenn zunächst das Gate-Oxid 15 und auf das Gate-Oxid 15 die Gate-Elektrode 16 aufgebracht wird. Anschließend werden nacheinander unter Verwendung dieser Gate-Elektrode 16 als Maske die erste Zone 12 bzw. die zweite Zone 13 selbstjustierend in den Halbleiterkörper 10 eingebracht.

Unter Verwendung der oben genannten Dotiermaske werden also in zwei getrennten Prozessschritten die Dotieratome für die α -Dotierung der ersten Zone 12 und die β-Dotierung für die zweite Zone 13 mittels eines Diffusionsprozesses in den Halbleiterkörper 1 eingebracht. Bei der Diffusion verteilen sich die Dotieratome lateral und vertikal, homogen gleichmäßig
über die entsprechenden Bereiche 12, 13. Es wäre jedoch auch denkbar, die Dotieratome durch Ionenimplantationen in den Halbleiterkörper 1 einzubringen. Die Ionenimplantation erweist sich gegenüber der Diffusion als vorteilhaft, da hier eine exakt messbare Dotierdosis in den Halbleiterkörper 1 einbringbar ist, wodurch eine exakte Kontrolle bzw. Einstellung der Schaltschwelle der ESD-Diode möglich ist. Der Ionenimplantation ist jedoch ein geeigneter Temperaturschritt anzuschließen, damit die Dotieratome zum einen elektrisch aktiviert werden und durch den Ionenbeschuss erzeugte Kristallschäden ausgeheilt werden. Ob eine Ionenimplantation oder Diffusion zur Herstellung der Bereiche 12, 13 zur Anwendung kommt, richtet sich typischerweise nach dem jeweiligen Prozessablauf.

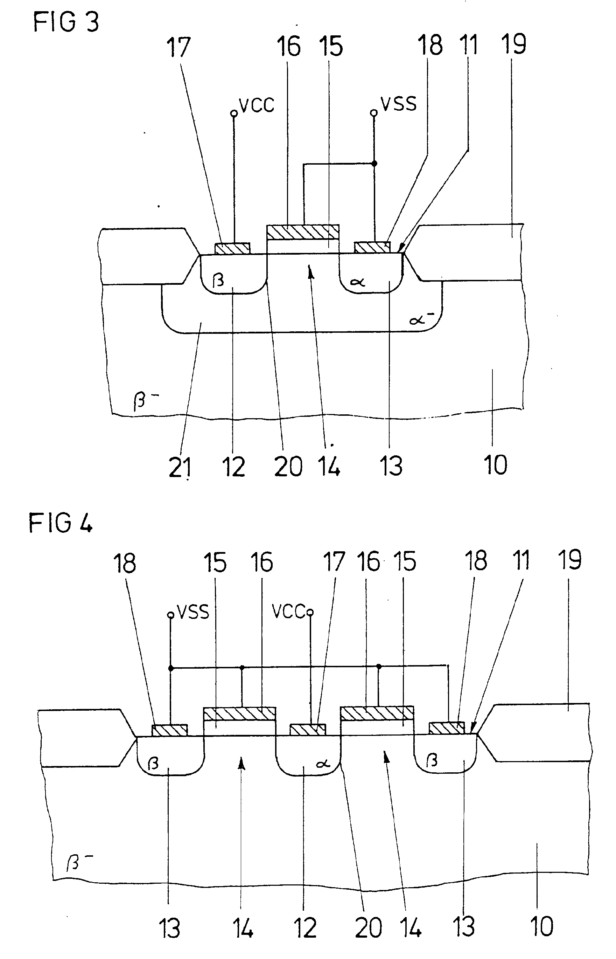

Figur 3 zeigt in einem Teilschnitt ein zweites Ausfuhrungsbeispiel einer ESD-Diode. In Figur 2 ist zusätzlich eine schwach α-dotierte Wanne 21, beispielsweise durch Diffusion, in den Halbleiterkörper 10 eingebracht worden. In diese Wanne 21 sind entsprechend Figur 2 die voneinander beabstandeten Zone 12, 13 eingebettet. In Abwandlung zu Figur 2 sind jedoch hier die Leitfähigkeitstypen der ersten Zone 12 und der zweiten Zone 13 vertauscht worden, dass heißt, die ersten Zone 12 ist nun β-dotiert und die zweite Zone 13 ist α-dotiert. Es ergibt sich somit eine in der Wanne 21 eingebettete ESD-Diode 7, die durch die genannte Maßnahme vorteilhafterweise vom Substat des Halbleiterkörpers 10 elektrisch isoliert ist.

Figur 4 zeigt ein drittes Ausführungsbeispiel einer ESD-Diode 7 entsprechend Figur 2, bei der die erste Zone 12 lateral durch die zweiten Zonen 13 umschlossen ist. Auf diese Weise wird das Substrat rings um die ESD-Diode 7 stets auf einem definierten Potential gehalten, wodurch ein deutlich verbesserter Latch-up-Schutz erzielt werden kann.

Die erfindungsgemäße ESD-Dioden 7 entsprechend der Figuren 2 bis 4 schützen somit die zu schützende Schaltung 6 und damit auch die integrierte Schaltung 1 insbesondere bei Hochspannungsanwendungen sehr effektiv und zeigt darüber hinaus nahezu keine Wanderungseffekte in der Kennlinie.

Die ESD-Struktur kann ein kreisförmiges, kreisringförmiges, quadratisches, mäanderförmiges, fingerförmiges, fächerförmiges oder ähnliches Layout aufweisen.

Im vorliegenden Ausführungsbeispiel wurde eine lateral ausgebildete ESD-Diode 7 beschrieben. Denkbar wäre hier auch eine vertikal ausgebildete ESD-Diode 7, wenngleich diese technologisch auch sehr viel aufwendiger ist. Solche vertikal ausgebildeten ESD-Strukturen unter Verwendung einer Epitaxieschicht und/oder einer vergrabenen Schicht (engl.: burrid layer) können insbesondere bei in Trench-Technologie ausgebildeten integrierten Halbleiterschaltungen 1 verwendet werden.

Für alle Ausführungsbeispiele der Figuren 2 bis 4 lassen sich selbstverständlich durch Austauschen aller Leitfähigkeitstypen α gegen β neue mögliche Ausführungsbeispiele bereitstellen.

Die erfindungsgemäße ESD-Diode eignet sich insbesondere bei MOS/CMOS-integrierten Schaltungen, die einen Schutz der Versorgungsspannungsnetze gegen ESD-Überspannungen benötigen. Dies sind insbesondere alle integrierten Schaltungen mit analogen Funktionen mit eigener analoger Versorgungsspannung, insbesondere solche analogen Schaltungen, die mit hoher Betriebsspannung arbeiten und somit praktisch keinen Eigenschutz besitzen. Die Erfindung eignet sich jedoch auch bei allen digital ausgebildeten integrierten Halbleiterschaltungen mit Hochvoltversorgungsspannungsnetz.

Zusammenfassend kann festgestellt werden, das durch die wie beschrieben aufgebaute und betriebene erfindungsgemäße ESD-Diode 7 nahezu ohne Mehraufwand und vorteilhafterweise in einem selbstjustierenden MOS-Prozess ein optimaler ESD-Schutz mit einfachen Mitteln gewährleitet ist, ohne dass gleichzeitig die Nachteile von ESD-Dioden nach dem Stand der Technik in Kauf genommen werden müssen. Die ESD-Diode 7 ist bei beliebigen MOS- oder CMOS-Schaltungen verwendbar.

Die vorliegende Erfindung wurde anhand der vorstehenden Beschreibung so dargelegt, um das Prinzip der Erfindung und dessen praktische Anwendung am besten zu erklären. Selbstverständlich lässt sich die vorliegende Erfindung im Rahmen des fachmännischen Handelns in geeigneter Weise in mannigfaltigen Ausführungsformen und Abwandlungen realisieren.

### Bezugszeichenliste

- 1: integrierte Halbleiterschaltung
- 2: Versorgungsspannungseingang
- 3: Versorgungsspannungseingang
- 4: erste Potentialschiene
- 5: zweite Potentialschiene
- 6: zu schützende Schaltung
- 7: ESD-Schutzelement, ESD-Diode
- 10: Halbleiterkörper
- 11: Oberfläche des Halbleiterkörpers
- 12: erster Bereich
- 13: zweiter Bereich
- 14: Driftzone
- 15: Gateoxid, Gatedielektrikum
- 16: Gateelektrode
- 17: erste Elektrode,
- 18: zweite Elektrode,
- 19: Feldoxid
- 20: pn-Übergang
- 21: Wanne

- VCC: erstes Versorgungspotential
- VSS: zweites Versorgungspotential, Bezugsmasse
- W: Weite

## Patentansprüche

1. ESD-Schutzstruktur zum Schutz einer zwischen einer ersten Potentialschiene (4) mit einem ersten Versorgungspotential (VCC) und einer zweiten Potentialschiene (5) mit einem zweiten Versorgungspotential (VSS) geschalteten, integrierten Halbleiterschaltung (1) vor elektrostatischer Entladung, mit einer lateral ausgebildeten ESD-Diode (7), die mindestens einen ersten Bereich (12) des ersten Leitungstyps und mindestens einen vom ersten Bereich (12) beabstandeten, zweiten Bereich (13) des zweiten, entgegengesetzten Leistungstyps aufweist, die zwischen den Potentialschienen (4, 5) angeordnet ist und die einen Überspannungsimpuls auf eine Potentialschiene (4, 5) ableitet,
**dadurch gekennzeichnet, dass** eine Gate-elektrode (16) vorgesehen ist, wobei der erste Bereich (12) und der zweite Bereich (13) bezüglich der Gateelektrode (16) justiert sind und der Abstand zwischen dem ersten Bereich (12) und dem zweiten Bereich (13) der Weite (W) oder der Länge der Gateelektrode (16) entspricht.

2. ESD-Schutzstruktur nach Anspruch 1,
**dadurch gekennzeichnet, dass** ein Halbleiterkörper (10) vorgesehen ist, der eine Oberfläche (11) aufweist, in die der ersten Bereich (12) und der zweite Bereich (13) eingebettet sind, wobei der ersten Bereich (12) über eine erste Elektrode (17) mit der ersten Potentialschiene (4) und der zweite Bereich (13) über eine zweite Elektrode (13) mit der zweiten Potentialschiene (5) verbunden ist.

3. ESD-Schutzstruktur nach Anspruch 2,
**dadurch gekennzeichnet, dass** der Halbleiterkörper (10) Ladungsträger des zweiten Leitungstyps aufweist und die Gateelektrode (16) und die zweite Elektrode (18) an die zweite Potentialschiene (5) angeschlossen sind.

4. ESD-Schutzstruktur nach Anspruch 2,
**dadurch gekennzeichnet, dass** der Halbleiterkörper (10) Ladungsträger vom ersten Leitungstyp aufweist und in den Halbleiterkörper (10) mindestens eine Wanne (21) des zweiten Leitungstyps eingebettet ist, in der die ersten und die zweiten Bereiche (12, 13) eingebettet sind.

5. ESD-Schutzstruktur nach einem der vorstehenden Ansprüche,
**dadurch gekennzeichnet, dass** die zweiten Bereiche (13) die ersten Bereiche (12) lateral umschließen.

6. ESD-Schutzstruktur nach einem der vorstehenden Ansprüche,
**dadurch gekennzeichnet, dass** die integrierte Halbleiterschaltung (1) eine MOS- oder eine CMOS-Schaltung ist.

7. ESD-Schutzstruktur nach einem der vorstehenden Ansprüche,
**dadurch gekennzeichnet, dass** ein Gatedielektrikum (15) vorgesehen ist, das den Halbleiterkörper (10) von der Gateelektrode (16) beabstandet.

8. ESD-Schutzstruktur nach Anspruch 7,
**dadurch gekennzeichnet, dass** das Gatedielektrikum (15) Siliziumdioxid und die Gateelektrode (16) Polysilizium enthält.

9. Verfahren zur Herstellung einer ESD-Schutzstruktur nach einem der vorstehenden Ansprüche, mit den folgenden Verfahrensschritten:
- Einbringen von Dotieratomen des ersten Leitungstyps für den ersten Bereich (12);
- Einbringen von Dotieratomen des zweiten Leitungstyps für den zweiten Bereich (13);
- Aufbringen eines Gatedielektrikums (15) auf die erste Oberfläche (11) über einem Anreicherungsgebiet (14) , welches zwischen dem ersten Bereich (12) und dem zweiten Bereich (13) angeordnet ist;
- Aufbringen jeweils einer Metallisierung oder einer Polysiliziumschicht auf die ersten und die zweiten Bereiche (12, 13) sowie auf das Gatedielektrikum (15).

10. Verfahren nach Anspruch 9,
**dadurch gekennzeichnet, dass** zunächst das Gatedielektrikum (15) und die Gateelektrode (16) hergestellt werden und anschließend die ersten und die zweiten Bereiche (12, 13) selbstjustierend unter Verwendung des Gatedielektrikums (15) als Maske in den Halbleiterkörper (1) eingebracht werden.

11. Verfahren nach einem der Ansprüche 9 oder 10,
**dadurch gekennzeichnet, dass** die Dotierstoffe für den ersten Bereich (12) und/oder für den zweiten Bereich (13) und/oder für die Wanne (21) durch Ionenimplantation in den Halbleiterkörper (1) eingebracht werden.

12. Verfahren nach einem der Ansprüche 9 bis 11,
**dadurch gekennzeichnet, dass** die integrierte Halbleiterschaltung (1) und die ESD-Diode (7) in MOS-Technologie oder CMOS-Prozesstechnologie hergestellt werden.

13. Verfahren zur Herstellung einer Dotiermaske zur Durchführung eines Verfahrens nach einem der Ansprüche 9 bis 12 oder zur Herstellung einer ESD-Schutzstuktur nach einem der Ansprüche 1 bis 8,
**dadurch gekennzeichnet, dass** für die ESD-Diode (7) das Layout eines feldeffektgesteuerten Transistors verwendet wird, wobei im Layout jeweils bei einem für einen Source-Bereich (12) oder einen Drain-Bereich (13) des feldeffektgesteuerten Transistors vorgesehener Bereich der Leitungstyp vertauscht wird und die Elektrode (18) dieses Bereichs gleichzeitig mit der Gateelektrode (16) kurzgeschlossen wird.
